(19) Europäisches Patentamt

European Patent Office

Office européen des brevets

(11) Veröffentlichungsnummer: **0 303 065 B1**

# (12) EUROPÄISCHE PATENTSCHRIFT

(45) Veröffentlichungstag der Patentschrift: **30.09.92**

(51) Int. Cl.⁵: **G06F 11/00**

(21) Anmeldenummer: **88111326.0**

(22) Anmeldetag: **14.07.88**

(54) Verfahren und Schaltungsanordnung für Halbleiterbausteine mit in hochintegrierter Schaltkreistechnik zusammengefassten logischen Verknüpfungsschaltungen.

(30) Priorität: **10.08.87 DE 3726570**

(43) Veröffentlichungstag der Anmeldung:
**15.02.89 Patentblatt 89/07**

(45) Bekanntmachung des Hinweises auf die Patenterteilung:
**30.09.92 Patentblatt 92/40**

(84) Benannte Vertragsstaaten:
**AT BE CH DE FR GB IT LI NL SE**

(56) Entgegenhaltungen:
**EP-A- 0 111 053**
**WO-A-86/03592**
**US-A- 3 812 336**

**PROCEEDINGS OF THE IEEE INTERNATIONAL CONFERENCE ON CIRCUITS AND COMPUTERS, ICCC'82, 28. September - 1. Oktober 1982, Seiten 198-201, IEEE, New York, US; V.G. OKLOBDZIJA et al.: "Testability enhancement of VLSI using circuit structures"**

(73) Patentinhaber: **Siemens Nixdorf Informationssysteme AG**
**Otto-Hahn-Ring 6**
**W-8000 München 83(DE)**

(72) Erfinder: **Eckenberger, Eberhard,**
**Bettinastrasse 23**
**W-8000 München 83(DE)**
Erfinder: **Köhler, Manfred**
**Eichenstrasse 4B**
**W-8011 Putzbrunn(DE)**
Erfinder: **Nussbächer, Hans-Klaus**
**Nadistrasse 51**
**W-8000 München 40(DE)**

(74) Vertreter: **Fuchs, Franz-Josef, Dr.-Ing. et al**
**Postfach 22 13 17**
**W-8000 München 22(DE)**

**Beschreibung**

Die Erfindung betrifft ein Verfahren und eine Schaltungsanordnung zur nachträglichen Beeinflussung der Schaltkreisfunktionen von in Halbleiterbausteinen mit hochintegrierter Schaltkreistechnik zusammengefaßten logischen Verknüpfungsschaltungen.

Durch die hochintegrierte Schaltkreistechnik (LSI) werden immer komplexere Schaltkreise, bestehend aus einer Vielzahl von logischen Verknüpfungsschaltungen, in einem Halbleiterbaustein untergebracht. Zu den komplexesten Schaltkreisen zählen insbesondere solche, die Steuerungsaufgaben für zum Beispiel Prozessoren in einer Datenverarbeitungsanlage ausführen. Die Entwicklung und die Fertigstellung von Halbleiterbausteinen mit komplexen Schaltkreisen ist mit einem sehr hohen Kosten- und Zeitaufwand verbunden. Das liegt unter anderem daran, daß zu jedem Zeitpunkt der Entwicklungsphase bis hin zum fertigen Halbleiterbaustein immer wieder Fehler auftreten, die eine wenigstens teilweise Überarbeitung des bis zum Fehlerauftritt Geleisteten notwendig machen. Die Fehler können dabei technisch bedingt sein, zum Beispiel Fertigungsfehler, oder logisch bedingt sein, zum Beispiel Entwicklungsfehler. Besonders kritisch ist es, wenn die Fehler zu einem späten Zeitpunkt auftreten. Zu einem späten Zeitpunkt treten oft Entwicklungsfehler auf, die dadurch entstanden sind, daß Anforderungen, die letztlich an den Halbleiterbaustein gestellt werden, von Anfang an nicht bedacht worden sind. Aufgrund der Kompliziertheit des in den Halbleiterbaustein einzubringenden komplexen Schaltkreises kann am Anfang der Entwicklung oft nicht in vollem Umfang abgesehen werden, welche Anforderungen letztlich an den Halbleiterbaustein zu stellen sind. Aus diesem Grund wird während der Entwicklungsphase öfters ein verbesserter Prototyp des Halbleiterbausteins hergestellt, der aber jedesmal Verlustzeiten in der Entwicklung mit sich bringt und den Halbleiterbaustein dadurch verteuert. Es werden dann Möglichkeiten gesucht, um die Kosten für den Halbleiterbaustein zu senken.

Zur Senkung der Kosten für Halbleiterbausteine mit in hochintegrierter Schaltkreistechnik zusammengefaßten Verknüpfungsschaltungen ist zum Beispiel aus der DE-PS 31 16 659 bekannt, die Verknüpfungsschaltungen so aufzuschlüsseln, daß der durch die Verknüpfungsschaltungen gebildete Schaltkreis durch mehrere gleichartige Halbleiterbausteine gebildet wird. Erreicht wird dies dadurch, daß die Verknüpfungsfunktionen der Verknüpfungsschaltungen in zwei Gruppen eingeteilt werden, nämlich in gleichartige Verknüpfungsfunktionen, die mehrmals parallel mit gleichen Logikschaltungen auszuführen sind und ganze Gruppen gleichartiger Ausgangssignale liefern, und in ungleichartige Verknüpfungsfunktionen, die jeweils individuelle Logikschaltungen erfordern. Dabei werden die Logikschaltungen für die Durchführung gleichartiger Verknüpfungsfunktionen gleichmäßig auf alle Halbleiterbausteine des Schaltkreises verteilt, während die Logikschaltungen für alle ungleichartigen Verknüpfungsfunktionen in gleicher Weise auf jedem Halbleiterbaustein, also entsprechend mehrfach, vorgesehen werden. Durch steuerbare Auswahlschalter wird dann das jeweils mehrfach gebildete Verknüpfungsergebnis einer vorgegebenen logischen Verknüpfungsfunktion bei einem der Halbleiterbausteine für die weitere Verarbeitung als Ausgangssignal an einer vorgegebenen Ausgangsklemme freigegeben. Jeder von n Halbleiterbausteinen kann also alle Ausgangssignale in homogener Struktur bilden, genutzt wird jedoch nur ein vorbestimmter Teil davon, während jeweils nur 1 durch n der Ausgangssignale homogener Struktur auf jedem Halbleiterbaustein gebildet wird. Insgesamt wird der Schaltkreis durch n einheitliche Halbleiterbausteine gebildet, wodurch die Produktion der Halbleiterbausteine für den Schaltkreis um das n fache gesteigert wird. Gleichzeitig wird aber auch der Komplexitätsgrad um das 1 durch n fache gesenkt. Bestehen bleibt weiterhin die Fehleranfälligkeit der Halbleiterbausteine bezüglich Entwicklungs- und Fertigungsfehler, so daß immer noch das Problem langer Entwicklungszeiten besteht. Ein anderes Problem ist die beschränkte Verwendbarkeit der Halbleiterbausteine für zum Beispiel erweiterte Aufgabengebiete, da sie speziell für die Schaltkreisfunktionen der ursprünglichen Verknüpfungsschaltungen ausgelegt sind.

Eine andere Möglichkeit, die Kosten für die Entwicklung eines Halbleiterbausteins mit hochintegrierter Schaltkreistechnik zu senken, besteht darin, die Entwicklungs- und Fertigungszeiten zu verkürzen. Das könnte dadurch geschehen, daß bei Auftreten eines Fehlers, oder bei Auftreten von Neuanforderungen an den Halbleiterbaustein, nicht immer ein neuer Prototyp hergestellt werden muß. Erreicht werden kann das dadurch, daß im Bedarfsfall eine nachträgliche Beeinflussung der Schaltkreisfunktionen des Halbleiterbausteins möglich ist, so daß er auch im Fehlerfall oder bei Auftreten von Neuanforderungen verwendbar bleibt. Um den Halbleiterbaustein in den erwähnten Fällen verwendbar zu halten, könnten an wesentlichen Stellen der Verknüpfungsschaltungen zusätzliche Ein- und Ausgänge vorgesehen werden, durch die nachträglich durch entsprechende externe Beschaltung der Eingänge an fehlerfreien Stellen der Verknüpfungsschaltungen ersatzweise oder neue Verknüpfungsfunktionen gebildet und die Ergebnisse den entsprechenden Stellen zugeführt werden können. Bei komplexen Schaltkreisen, wie zum Beispiel solchen zur Steuerung von Prozessoren in Datenverarbeitungsanlagen, ist aber bereits eine große Zahl von regulären Ein- und Ausgängen am Halbleiterbaustein vorhanden, so daß für zusätzliche Ein- und Ausgänge kaum Platz zur Verfügung steht. Es wären aber hierfür eine Vielzahl von zusätzlichen Ein- und Ausgängen am Halbleiterbaustein notwendig.

Aufgabe der Erfindung ist ein Verfahren zur nachträglichen Beeinflussung der Schaltkreisfunktionen von in Halbleiterbausteinen mit hochintegrierter Schaltkreistechnik zusammengefaßten logischen Verknüpfungsschaltungen, das mit wenigen zusätzlichen Anschlußstiften am Halbleiterbaustein auskommt und trotzdem die Verwendung des Halbleiterbausteins auch bei Auftreten von Fehlern, wie zum Beispiel Fertigungs- oder Entwicklungsfehler, oder von Neuanforderungen in vielen Fällen gewährleistet, sowie eine Schaltungsanordnung zur Ausführung des Verfahrens.

Gelöst wird die Aufgabe für das Verfahren durch die im kennzeichnenden Teil des Patentanspruches 1 angegebenen Merkmale. Danach werden an den Eingangsverknüpfungselementen der Verknüpfungsschaltungen des aus Verknüpfungsschaltungen zusammengesetzten Schaltkreises zusätzlich Eingänge vorgesehen, die so beschaltet werden, daß sie für die Verwirklichung der Schaltkreisfunktionen zunächst unberücksichtigt bleiben. Weiter wird dem Schaltkreis ein Schaltungsteil im Halbleiterbaustein vorgeschaltet, der entweder nur eine Signalzuordnungsanordnung oder nur eine Verknüpfungsanordnung, oder eine Signalzuordnungs- und eine Verknüpfungsanordnung aufweist und alle im Schaltkreis zusätzlich vorgesehenen Eingänge ansteuert.

Falls der Schaltungsteil nur eine Signalzuordnungsanordnung aufweist, erhält die Signalzuordnungsanordnung eingangsseitig die über Anschlußstifte des Halbleiterbausteins verfügbaren Eingangssignale, sowie von Teilen der Verknüpfungsschaltungen abgeleitete Eingangssignale. Die Signalzuordnungsanordnung wählt extern gesteuert Eingangssignale aus und führt diese einzeln oder gruppenweise kombiniert einzelnen Steuereingängen verschiedener Anfangsverknüpfungselemente zu. Im Bedarfsfall können dadurch an vorbestimmten Steuereingängen entsprechende Signale eingespeist und dadurch Fehlerstellen umgangen, oder insgesamt neue Verknüpfungsfunktionen gebildet werden. Hierfür genügt eine geringe Anzahl von zusätzlichen Anschlußstiften am Halbleiterbaustein, weil die Signalzuordnungsanordnung die vielfältigsten Zuordnungen zwischen den ihr zur Verfügung gestellten Eingangssignalen und den zusätzlich in den Verknüpfungsschaltungen vorgesehenen Steuereingängen gestattet.

Falls der den Verknüpfungsschaltungen vorgeschaltete Schaltungsteil nur eine Verknüpfungsanordnung aufweist, sind zwar die Ausgangssignale vorgegebenen Steuereingängen der Anfangsverknüpfungselemente der Verknüpfungsschaltungen fest zugeordnet, doch lassen sich durch Abändern bzw. Neuverknüpfung von Signalen nachträglich fehlerhafte Signale korrigieren bzw. fehlende Signale erzeugen. Bei Verwendung eines mit Laserstrahlen programmierbaren Logikfeldes als Verknüpfungsanordnung werden sogar keine weiteren Anschlußstifte am Halbleiterbaustein benötigt.

Weist der besagte Schaltungsteil beide Anordnungen gleichzeitig auf, wird durch das Zusammenwirken die Mannigfaltigkeit an nachträglichen Einflußmöglichkeiten gegenüber den Einzelanordnungen nochmals erhöht.

Der Platzbedarf für die zusätzliche Hardware ist im Verhältnis zur Hardware der Verknüpfungsschaltungen gering. In hochintegrierten Halbleiterbausteinen ist für diese geringe Hardware stets genügend Platz vorhanden. Sie ist aber in der Entwicklungsphase von komplexen Verknüpfungsschaltungen in hochintegrierter Schaltkreistechnik vorteilhaft, weil die hierfür häufig auftretenden Fehler sofort durch entsprechende Beschaltung der zusätzlichen Steuereingänge innerhalb der Verknüpfungsschaltungen beseitigt werden können. Daneben ist durch Neubildung von Verknüpfungsfunktionen eine sofortige Anpassung an geänderte Anforderungen möglich. Es werden die Entwicklungszeiten und damit die Kosten für den Halbleiterbaustein erheblich reduziert, weil nicht jeder Fehler oder jede auftretende Neuanforderung an den Halbleiterbaustein zur Herstellung eines verbesserten Prototypen führt. Weiterhin vorteilhaft ist, daß der Komplexitätsgrad des Halbleiterbausteins nicht vermindert wird, wodurch komplexe Schaltkreise in einem Halbleiterbaustein untergebracht werden können.

Bei einer Weiterbildung der Erfindung wird bei Verwendung eines vorgeschalteten Schaltungsteiles mit Verknüpfung der zugeführten Eingangssteuersignale wenigstens ein Teil dieser Eingangssteuersignale dem Schaltungsteil über eine extern steuerbare Signalzuordnungsanordnung zugeführt, die in der Arbeitsweise und Funktion der bereits erwähnten Signalzuordnungsanordnung entspricht. Dadurch erhöhen sich die Möglichkeiten, die zusätzlichen Steuereingänge der Verknüpfungsschaltungen mit entsprechenden Signalen zu versorgen, um ein Vielfaches. Insgesamt wird der Halbleiterbaustein dadurch universeller einsetzbar.

Die Steuerung der Signalzuordnungsanordnung bzw. -ordnungen erfolgt vorteilhafterweise mittels eines Schieberegisters, so daß am Halbleiterbaustein nur der Ein- und Ausgang sowie die Takte des Schieberegisters für dessen Versorgung mit einer Steuerinformation notwendig sind. Zur Verringerung der Schieberegisterlänge kann dem Schieberegister ein Demultiplexer nachgeschaltet werden, so daß die Steuerinformation in codierter Form eingeschoben werden kann. Eine Schaltungsanordnung zur Ausführung des Verfahrens gemäß der Erfindung ist gekennzeichnet durch die im Patentanspruch 4 angegebenen Merkmale. Danach ist den Verknüpfungsschaltungen innerhalb des Halbleiterbausteins eine Signalzuordnungsanordnung vorgeschaltet, die die an den Anfangsverknüpfungselementen der Verknüpfungsschaltungen zusätzlich vorgesehenen Steuereingänge ansteuert. In Weiterbildungen der Erfindung sind der Signalzuordnungsanordnung eine externe programmierbare Verknüpfungsanordnung, und dieser wiederum eine weitere Signalzuordnungsanordnung vorgeschaltet. Dadurch können ausgehend von wenigen, über Anschlußstifte des Halbleiterbausteins extern eingespeisten Eingangssignalen viele verschiedene Signale zur einzelnen oder gruppenweise kombinierten Ansteuerung der in den Verknüpfungsschaltungen zusätzlich vorgesehenen Eingängen erzeugt werden.

Eine weitere Schaltungsanordnung zur Ausführung des Verfahrens gemäß der Erfindung ist gekennzeichnet durch die im Patentanspruch 6 angegebenen Merkmale. Danach ist den Verknüpfungsschaltungen innerhalb des Halbleiterbausteins eine Verknüpfungsanordnung vorgeschaltet, über die die den Verknüpfungsschaltungen zugeführten Signale geführt und in vorbestimmter Weise beeinflußt werden. Vorteilhafterweise ist der Verknüpfungsanordnung zusätzlich eine Signalzuordnungsanordnung vorgeschaltet, die nochmals eine Auswahlmöglichkeit von Signalen an den Verknüpfungsanordnungseingängen zuläßt.

Den Signalzuordnungsanordnungen ist ein Steuerungsteil vorgeschaltet, der ein Schieberegister mit gegebenenfalls nachgeschaltetem Demultiplexer aufweist, wodurch nur zwei zusätzliche Anschlußstifte am Halbleiterbaustein notwendig sind.

Einzelheiten der Erfindung werden anhand der Zeichnung näher erläutert. Darin zeigt:

FIG 1      ein Prinzipschaltbild einer ersten Schaltungsanordnung gemäß der Erfindung,

FIG 2      ein Prinzipschalt einer zweiten Schaltungsanordnung gemäß der Erfindung,

FIG 3      eine Weiterbildung der in FiG 1 bzw. FIG 2 gezeigten Schaltungsanordnung,

FIG 4      ein Beispiel für den Steuerungsteil der in FIG 1 bis FIG 3 gezeigten Signalzuordnungsanordnung,

FIG 5      ein Beispiel für die in FIG 1 bis FIG 3 gezeigten Signalzuordnungsanordnungen,

FIG 6      ein Beispiel für ein Anfangsverknüpfungselement einer Verknüpfungsschaltung,

FIG 7      ein Beispiel für zwei Anfangsverknüpfungselemente zweier zusammenwirkender Verknüpfungsschaltungen,

FIG 8      Ein weiteres Beispiel für zwei Anfangsverknüpfungselemente zweier zusammenwirkender Verknüpfungsschaltungen,

FIG 9      ein Beispiel für eine Verknüpfungsanordnung,

FIG 10      ein erstes Teilausführungsbeispiel der Schaltungsanordnung nach FIG 2 und

FiG 11      ein weiteres Teilausführungsbeispiel der Schaltungsanordnung nach FIG 2

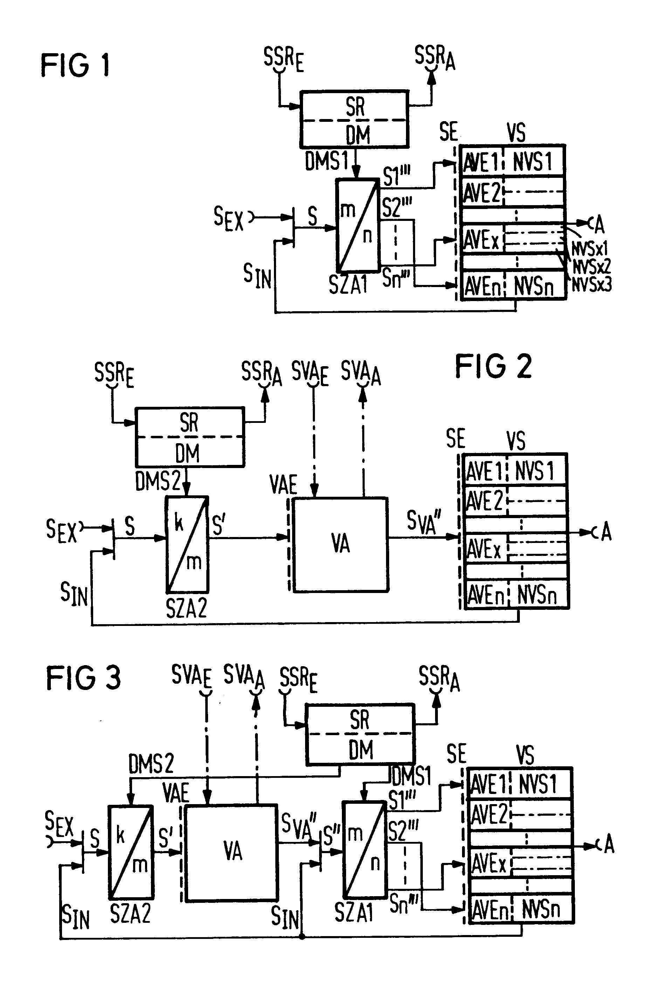

FIG 1 zeigt einen Halbleiterbaustein in hochintegrierter Schaltkreistechnik mit einem aus mehreren Verknüpfungsschaltungen VS zusammengesetzten Schaltkreis. Die Verknpüpfungsschaltungen weisen je ein Anfangsverknüpfungselement AVE auf, die von den Eingangssignalen angesteuert werden. Ein Anfangsverknüpfungselement kann dabei entweder genau eine nachfolgende Verknüpfungsschaltung NVS mit Eingangssignalen versorgen oder gleichzeitig mehrere (zum Beispiel NVSx1, NVSx2, NVSx3). Es sind auch Verbindungen zwischen den einzelnen Verknüpfungsschaltungen möglich. Die Anfangsverknüpfungselemente weisen jeweils wenigstens einen zusätzlichen Eingang auf, der so beschaltet ist, daß die festgelegten Schaltkreisfunktionen durch sie zunächst nicht verändert werden. Zusammen stellen sie eine Gruppe von zusätzlichen Steuereingängen innerhalb der Steuereingänge SE der Verknüpfungsschaltungen dar. Am Ausgang A werden die aufgrund der festgelegten Schaltkreisfunktionen gebildeten Ausgangssignale über Anschlußstifte ausgegeben. Von Teilen der Verknüpfungsschaltungen werden interne Signale $S_{IN}$ abgeleitet, die einen Teil der Eingangssignale der den Verknüpfungsschaltungen VS vorgeschalteten Signalzuordnungsanordnung SZA1 bilden. Der andere Teil der Eingangssignale $S_{EX}$ wird extern von den zusätzlich am Halbleiterbaustein vorgesehenen Anschlußstiften zur Verfügung gestellt. Zusammen mit den internen Eingangssignalen $S_{IN}$ bilden sie die Eingangssignale S der Signalzuordnungsanordnung SZA1. Die Signalzuordnungsanordnung SZA1 führt eine Zuordnung von maximal m Eingangssignalen auf maximal n Ausgangssignale durch. Die n Ausgangssignale steuern alle zusätzlichen Eingänge der Anfangsverknüpfungselemente. Es muß dabei aber nicht immer so sein, daß alle Ausgangssignale $S1'''$ bis $Sn'''$ der Signalzuordnungsanordnung SZA1 jeweils Eingangssignale weiterleiten. Es kann auch ein einzelnes Eingangssignal der Eingangssignalgruppe S gleichzeitig an mehrere Ausgangssignale S''' weitergeleitet werden. Insgesamt ist ein vielfältiges Zuordnen zwischen den Eingangssignalen S und den Ausgangssignalen S''' der Signalzuordnungsanordnung SZA1 möglich.

Die Signalzuordnungsanordnung SZA1 wird durch extern angelieferte Steuersignale SSR gesteuert, die seriell über den Eingang $SSR_E$ in ein Schieberegister SR eingeschrieben werden. Die dabei überzähligen Bitsignale werden zur Weiterverarbeitung am Ausgang $SSR_A$ ausgegeben. Durch einen nachgeschalteten Demulitplexer DM können codierte Steuersignale in das Schieberegister SR geschrieben werden, wodurch die benötigte Schieberegisterlänge verkürzt wird. Der Demultiplexer DM stellt die die Signalzuordnungsanordnung letztlich steuernde Steuersignalgruppe DMS1 bereit.

Gegenüber FIG 1 ist in FIG 2 zwischen dem aus mehreren Verknüpfungsschaltungen VS zusammengesetzten Schaltkreis und der jetzt neu benannten Signalzuordnungsanordnung SZA2 eine Verknüpfungsanordnung VA eingefügt. Die Signalzuordnungsanordnung SZA2 wird mittels den aus dem Demultiplexer DM stammenden Steuersignalen gesteuert, wobei sie eine beliebige Zuordnung von maximal k Eingangssignalen S zu maximal m Ausgangssignalen S' durchführt. Die Signalzuordnungsanordnung SZA2 samt Steuerteil kann aber auch eingespart sein.

Die Steuereingänge SE der Verknüpfungsschaltungen werden mit den Ausgangssignalen $S_{VA}''$ der Verknüpfungsanordnung VA versorgt. Hierbei handelt es sich um eine feste Zuordnung von Verknüpfungsanordnungsausgängen zu Verknüpfungsschaltungseingängen. Die Verknüpfungsanordnung VA führt entweder eine Signalkorrektur, eine gegenüber den Verknüpfungsschaltungen weitere Verknüpfung oder beides durch. Sie ist extern entweder mittels Laserstrahlen programmierbar, weshalb dann keine weiteren Stifte am Halbleiterbaustein benötigt werden, oder elektrisch über zum Beispiel einen Schiebebus programmierbar bzw. steuerbar, wodurch nur zwei zusätzliche Anschlußstifte $SVA_E$ und $SVA_A$ benötigt werden, falls dieser ein eigenständiger, also mit keinem anderen, zum Beispiel mit dem SR-Register, gekoppelter Schiebebus ist.

Der in FIG 3 dargestellte Halbleiterbaustein stellt eine Weiterbildung sowohl des in FIG 1 als auch des in FIG 2 gezeigten Halbleiterbausteins dar. Gegenüber dem Halbleiterbaustein aus FIG 1 sind der Signalzuordnungsanordnung SZA1 eine Verknüpfungsanordnung VA und eine zweite Signalzuordnungsanordnung SZA2 vorgeschaltet. Bezüglich des in FIG 2 dargestellten Halbleiterbausteins weist der in FIG 3 dargestellte Halbleiterbaustein zwischen der Verknüpfungsanordnung VA und dem die Verknüpfungsschaltungen aufweisenden Schaltkreis eine erste Signalzuordnungsanordnung SZA1 auf. Die Signalzuordnungsanordnung SZA2 ordnet abhängig von ihrer Einstellung über die Ausgangssignale S' die Eingangssignale S den Eingängen VAE der Verknüpfungsanordnung VA zu. Die Ausgangssignale $S_{VA}''$ der Verknüpfungsanordnung VA werden mit den internen Verknüpfungssignalen $S_{IN}$ "verknüpft", zum Beispiel mittels eines Multiplexers, und als Ergebnissignale S'' der Signalzuordnungsanordnung SZA1 als Eingangssignale zugeführt. Die Ausgangssignale S''' der Signalzuordnungsanordnung SZA1 werden dann abhängig von ihrer Einstellung den Steuereingängen SE den Verknüpfungsschaltungen VS zugeführt. Die Signalzuordnungsanordnungen SZA1 und SZA2 werden gemeinsam über das Schieberegister SR und dem nachfolgenden Demultiplexer DM gesteuert.

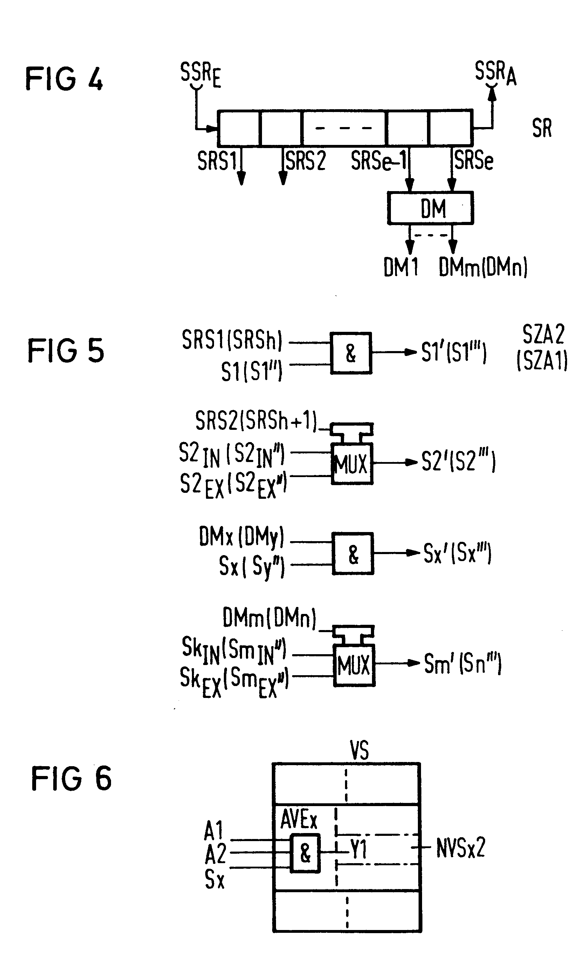

FIG 4 zeigt ein Beispiel für den die Signalzuordnungsanordnungen SZA1 und SZA2 steuernden, aus dem Schieberegister SR und gegebenenfalls aus einem nachfolgenden Demultiplexer DM zusammengesetzten Steuerteil. In das Schieberegister SR wird seriell die Steuerinformation SSR eingeschrieben. Die einzelnen Bitsignale SRS1 bis SRSe steuern die Signalzuordnungsanordnungen SZA1 und SZA2 direkt, falls kein nachfolgender Demultiplexer DM vorhanden ist. Die Länge des Schieberegisters SR hängt von der Summe der Eingangssignale der Signalzuordnungsanordnungen SZA1 und SZA2 ab. Um die Länge des Schieberegisters SR nicht zu groß werden zu lassen, wird der Demultiplexer DM nachgeschaltet. Es werden dann die Signalzordnungsanordnungen SZA1 und SZA2 durch die Bitstellensignale SRS1 bis DMm (DMn) gesteuert. Insgesamt bilden alle abgehenden Steuersignale die zum Beispiel in FIG 3 angegebenen Steuersignalgruppen DMS1 und DMS2.

FIG 5 zeigt ein Beispiel für die Signalzuordnungsanordnungen SZA1 und SZA2. Sie können im übrigen die unterschiedlichsten Gatterfunktionen aufweisen, um abhängig von den Bitstellensignalen SRS1 bis SRSe bzw. DMm (DMn) des Steuerteils verschiedene Zuordnungen von Eingangssignalen S zu Ausgangssignalen S' bzw. S''' durchzuführen. Für das Ausführungsbeispiel weisen sowohl die Signalzuordnungsanordnung SZA1 als auch die Signalzuordnungsanordnung SZA2 jeweils UND-Gatter, sowie Multiplexer auf. Zur Steuerung der Signalzuordnungsanordnung SZA2 wird das erste Eingangssignal S1 über ein UND-Gatter geführt und abhängig vom Bitstellensignal SRS1 als erstes Ausgangssignal S1' ausgegeben. Das zweite Eingangssignal S2, das sich in diesem Fall aus dem extern zur Verfügung gestellten Signal $S2_{EX}$ und dem intern zur Verfügung gestellten Signal $S2_{IN}$ zusammensetzt, wird über einen mittels dem zweiten Bitstellensignal SRS2 gesteuerten Multiplexer geführt und als zweites Ausgangssignal $S2'$ ausgegeben. Das Bitstellensignal SRS2 trifft eine Auswahl zwischen den Signalen $S2_{EX}$ und $S2_{IN}$. Das Xte Eingangssignal Sx wird über ein UND-Gatter geführt und abhängig vom Bitstellensignal DMx als Xtes Ausgangssignal $Sx'$ ausgegeben. Das letzte Eingangssignal Sk, das sich aus dem extern zur Verfügung gestellten Signal $Sk_{EX}$ und dem intern zur Verfügung gestellten Signal $Sk_{IN}$ zusammensetzt, wird über einen mittels dem Bitstellensignal DMm gesteuerten Multiplexer als Ausgangssignal $Sm'$ ausgegeben. Das Bitstellensignal DMm trifft eine Auswahl zwischen den Signalen $Sk_{EX}$ und $Sk_{IN}$. Für die Signalzuordnungsanordnung SZA1 gelten in analoger Weise die in FIG 4 und FIG 5 in Klammern angegebenen Signale. Die Buchstaben h und y dienen dabei zur Verallgemeinerung des Gesagten.

FIG 6 zeigt ein Beispiel für ein in der Xten Verknüpfungsschaltung VS verwendetes Anfangsverknüpfungselement AVEx. Es ist ein drei Eingänge aufweisendes UND-Gatter, das mit den Eingangssignalen A1, A2 und Sx angesteuert wird. Am Ausgang wird das Ergebnissignal Y1 ausgegeben. Der für das Steuersignal Sx vorgesehene Eingang ist für die Festlegung der durch die Verknüpfungsschaltung VSx verwirklichte Schaltkreisfunktion nicht maßgebend. Es handelt sich hierbei um einen zusätzlich in die Verknüpfungsschaltung VSx vorgesehenen Eingang zur nachträglichen Beeinflussung der Schaltkreisfunktion. Das Steuersignal Sx wird von der Signalzuordnungsanordnung SZA1 geliefert. Der Grundzustand dieses Signals ist so, daß keine Beeinflussung der Schaltkreisfunktion erfolgt, das heißt, Sx weist den logischen Wert 1 auf. Die IST-Funktion lautet demnach:

Y1, IST = A1 & A2    (UND-Verknüpfung)

Die Soll-Funktion an dieser Stelle sollte aber zum Beispiel lauten:

Y1, Soll = A1 & A2 & A3

Bei entsprechender Steuerung der Signalzuordnungsanordnung SZA1 kann über das Signal Sx das fehlende Signal A3 dem UND-Gatter zugeführt werden. Analoges gilt auch für andere Gatter als Anfangsverknüpfungselemente.

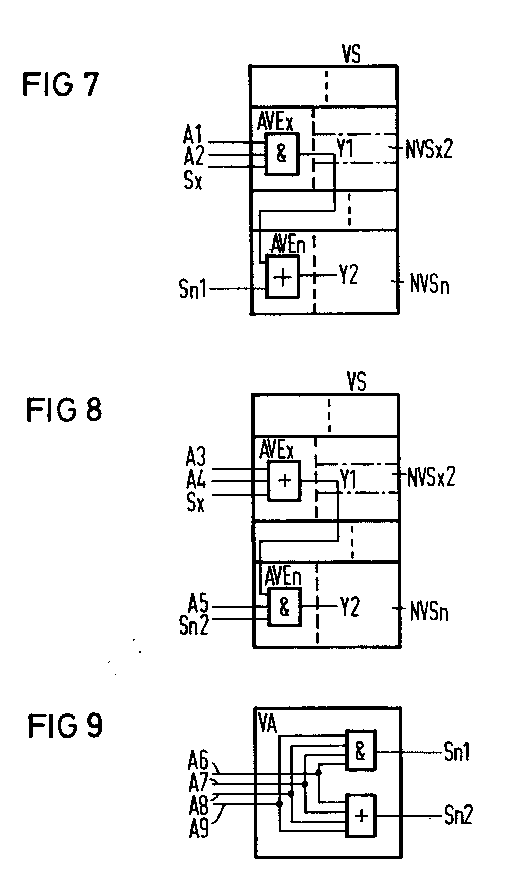

FIG 7 zeigt ein Beispiel für eine aufwendigere Schaltkreisfunktion. Dabei wirken die Xte Verknüpfungsschaltung VSx und die letzte Verknüpfungsschaltung VSn zusammen. Die Xte Verknüpfungsschaltung VSx weist ein UND-Gatter mit den Eingängen A1, A2 und Sx, und die letzte Verknüpfungsschaltung VSn weist ein ODER-Gatter mit den Eingängen Y1 und Sn1 auf. Das Ausgangssignal des ODER-Gatters bildet das Ausgangssignal Y2 der zusammengeschalteteten Verknüpfungsschaltungen. Für die Eingänge Sx und Sn1 gilt sinngemäß das für das Signal Sx in FIG 6 Gesagte. Sx weist demnach den logischen Wert 1, und Sn1 den logischen Wert 0 auf. Die für die zusammengeschaltete Verknüpfungsschaltung gültige IST-Funktion lautet dann:

Y2, IST = (A1 & A2) + 0    (UND - und ODER-Verknüpfung)

Als Beispiel soll aber Y2 folgender Verknüpfungsfunktion genügen:

Y2, Soll = A1 & A2 & A3 & A4

Durch entsprechende Steuersignale Sx und Sn1 muß dafür gesorgt werden, daß die geforderte Verknüpfungsfunktion an dieser Stelle entsteht. Hierzu wird von der Verknüpfungsanordnung VA mit den Signalen A6, A7, A8 und A9, die den Signalen A1, A2, A3 und A4 entsprechen, ein Signal Sn1 gemäß der Verknüpfungsfunktion:

Sn1 = A6 & A7 & A8 & A9

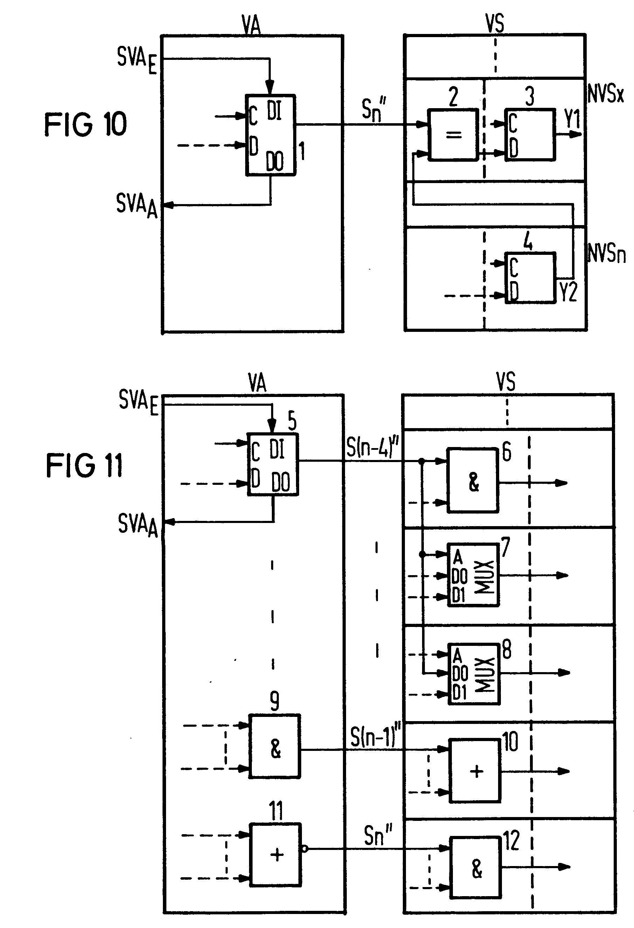

gebildet und mittels der Signalzuordnungsanordnung SZA1 an den Steuereingang Sn1 des Anfangsverknüpfungselementes AVEn der Verknüpfungsschaltung VSn gelegt. Gleichzeitig wird ein Sperrsignal Sx mit dem logischen Wert 0 mittels der Signalzuordnungsanordnung SZA1 an den Steuereingang Sx des Anfangsverknüpfungselementes AVEx der Verknüpfungsschaltung VSx gelegt. Die Bildung des Steuersignals Sn1 in der Verknüpfungsanordnung VA ist in FIG 9 zu sehen.

FIG 8 zeigt ein weiteres Beispiel entsprechend FIG 7. Hier sind jedoch die Anfangsverknüpfungselemente AVEx und AVn der Verknüpfungsschaltungen VSx und VSn vertauscht. Weiter weist das Anfangsverknüpfungselement AVEn der Verknüpfungsschaltung VSn einen dritten Eingang auf, an dem das Eingangssignal A5 anliegt. Für die Steuersignale Sx und Sn2 gilt sinngemäß das in FIG 7 für die Steuersignale Sx und Sn1 Gesagte. Das Steuersignal Sx weist demnach den logischen Wert 0 und das Steuersignal Sn2 den logischen Wert 1 auf. Es wird damit folgende IST-Funktion verwirklicht:

Y3, IST = A5 & (A3 + A4)

Als Beispiel sollte aber an dieser Stelle folgende SOLL-Funktion verwirklicht sein:

Y3, SOLL = (A6 + A7 + A8 + A9) & A5

In diesem Fall wird in der Verknüpfungsanordnung VA, wie in FIG 9 zu sehen, mit den Signalen A6, A7, A8 und A9 das Signal Sn2 gebildet, das über die Signalzuordnungsanordnung SZA1 dem Steuereingang Sn2 der Verknüpfungsschaltung VSn zugeführt wird, während ein Durchgangssignal Sx mit dem logischen Wert 1 an den Steuereingang Sx der Verknüpfungsschaltung VSx angelegt wird.

Im Ausführungsbeispiel für eine den Verknüpfungsschaltungen VS unmittelbar vorgeschaltete Verknüpfungsanordnung VA nach FIG 10 weist die Verknüpfungsanordnung VA ein Schieberegister 1 auf, das mittels der äußeren Anschlüsse $SVA_E$ und $SVA_A$ einstellbar ist. Das Schieberegister kann aber auch über den Dateneingang D abhängig vom Clocksignal C mit intern erzeugten Signalen gespeist werden. Das Ausgangssignal Sn″ des Schieberegisters 1 steuert das zur Verknüpfungsschaltung NVSx gehörende Anfangsverknüpfungselement 2, das durch ein Exklusiv-ODER-Gatter gebildet wird. Der zweite Eingang des Exklusiv-ODER-Gatters wird von der Verknüpfungsschaltung NVSn mit dem dort gebildeten Zwischensignal Y2 versorgt. Die Verknüpfungsschaltung NVSn wird durch das Flipflop 4 gebildet, das seinerseits mit intern abgeleiteten Signalen versorgt wird. Das EXKLUSIV-ODER-Gatter 2 versorgt die nachgeschaltete Verknüpfungsschaltung NVSx mit ihren Ausgangssignalen. Die nachgeschaltete Verknüpfungsschaltung NVSx wird durch das Flipflop 3 gebildet. Das Flipflop 3 liefert schließlich das Ergebnissignal Y1. Das Ergebnissignal Y1 entspricht dem Zwischensignal Y2, wenn das vom Schieberegister 1 der Verknüpfungsanordnung VA ankommende Signal Sn″ den logischen Signalpegel 0 aufweist. Ansonsten erhält das Flipflop 3 am Dateneingang des Zwischensignal Y2 negiert, so daß auch das Ausgangssignal Y1 gegenüber dem ursprünglichen Zwischensignal Y2 negiert erscheint. Erfüllt zum Beispiel die Verknüpfungsschaltung NVSn nicht ihren Bestimmungszweck, hervorgerufen durch zum Beispiel einen Fehler, kann trotzdem durch entsprechende Steuerung von der Verknüpfungsanordnung VA aus das gewünschte Ergebnissignal Y1 erzeugt werden.

Weitere Anwendungsmöglichkeiten sind der FIG 11 zu entnehmen. Hier wird wieder über ein einstellbares Schieberegister 5 der Verknüpfungsanordnung VA zum einen das UND-Gatter 6 innerhalb der Verknüpfungsschaltungen VS gesperrt, und zum anderen an jeweils einem Multiplexer 7 bzw. 8 der Steuereingang A bzw. der Dateneingang D0 in gewünschter Weise beeinflußt. Ein häufiger Anwendungsfall ist die Beeinflussung nachgeschalteter Gatter, zum Beispiel das UND-Gatter 9 wirkt mittels des Signals S(n-1)″ auf das ODER-Gatter 10. Ein weiterer häufiger Anwendungsfall ist zum Beispiel die Bildung des INHIBIT-Signals Sn″ durch das NOR-Gatter 11 für das UND-Gatter 12. Die Eingangssignale des NOR-Gatters 11 stellen verschiedene intern abgeleitete Bedingungen dar, die zum regulären Arbeiten des UND-Gatters 12 erfüllt sein müssen. Analoges gilt für die Eingangssignale des UND-Gatters 9.

**Patentansprüche**

1. Verfahren zur nachträglichen Beeinflussung der Schaltkreisfunktionen von in Halbleiterbausteinen mit hochintegrierter Schaltkreistechnik zusammengefaßten logischen Verknüpfungsschaltungen,
   **dadurch gekennzeichnet,** daß an den die Eingangssignale der Verknüpfungsschaltungen (VS) aufnehmenden Anfangsverknüpfungselementen (AVE) der Verknüpfungsschaltungen (VS) jeweils wenigstens ein Steuereingang (SE) bei der Festlegung der einzelnen Schaltungsfunktionen unberücksichtigt bleibt und daß alle Steuereingänge (SE) der Anfangsverknüpfungselemente (AVE) über einen gesonderten vorgeschalteten und extern steuerbaren Schaltungsteil, bestehend aus einer in Abhängigkeit von der externen Steuerung entweder eine Signalkorrektur, eine gegenüber den Verknüpfungsschaltungen (VS) weitere Verknüpfungen oder beides durchführenden Verknüpfungsanordnung (VA) und/oder einer bezüglich der Zuordnung von an mehreren zugehörigen Eingängen ankommenden Signalen zu unterschiedlich auswählbaren Ausgängen einer zugehörigen Ausgangsgruppe extern steuerbaren Signalzuordnungsanordnung (SZA1), angesteuert werden, dem die an den Anschlußstiften des Halbleiterbausteines verfügbaren Eingangssignale($S_{EX}$) und von Teilen der Verknüpfungsschaltungen (VS) gelieferte Zwischensignale ($S_{IN}$) als Eingangssteuersignale (S) zugeführt werden, so daß abhängig von der durch die externe Steuerung bewirkten Einstellung des vorgeschalteten Schaltungsteils die verfügbaren Eingangssteuersignale (S) in vorbestimmter Weise abgeändert und/oder einzeln oder gruppenweise kombiniert den einzelnen Steuereingängen (SE) verschiedener Anfangsverknüpfungselemente (AVE) zugeleitet werden.

2. Verfahren nach Anspruch 1,
   **dadurch gekennzeichnet,** daß bei Verwendung eines vorgeschalteten Schaltungsteiles mit Verknüpfung der zugeführten Eingangssteuersignale (S) wenigstens ein Teil dieser Eingangssteuersignale (S) dem Schaltungsteil über eine extern steuerbare Signalzuordnungsanordnung (SZA2) zugeführt wird, die abhängig von ihrer Einstellung die ihr zugeleiteten Eingangssteuersignale (S) einzeln oder gruppenweise kombiniert den Eingängen des vorgeschalteten Schaltungsteils zuführt.

3. Verfahren nach Anspruch 1 oder 2, **dadurch gekennzeichnet,** daß die Einstellungen der Signalzuordnungsanordnungen (SZA1 und/oder SZA2) über ein Schieberegister (SR) mit gegebenenfalls nachgeschaltetem Demultiplexer (DM) im Halbleiterbaustein erfolgt.

4. Schaltungsanordnung zur Ausführung des Verfahrens nach Anspruch 1, **dadurch gekennzeichnet,** daß den in Halbleiterbausteinen mit hochintegrierter Schaltkreistechnik zusammengefaßten logischen Verknüpfungsschaltungen (VS) mit an den Anfangsverknüpfungselementen (AVE) jeweils wenigstens einem bei der Festlegung der einzelnen Schaltkreisfunktionen unberücksichtigt bleibenden zusätzlichen Steuereingang (SE) eine bezüglich der Zuordnung von an mehreren zugehörigen Eingängen ankommenden Signalen zu unterschiedlich auswählbaren Ausgängen einer zugehörigen Ausgangsgruppe extern steuerbare Signalzuordnungsanordnung (SZA1) vorgeschaltet ist, die die an den Anschlußstiften des Halbleiterbausteines verfügbaren Eingangssignale ($S_{EX}$) und von Teilen der Verknüpfungsschaltungen (VS) gelieferte Zwischensignale ($S_{IN}$) als Eingangssignale (S) zugeführt bekommt und mit ihren Ausgangssignalen (S'") alle Steuereingänge (SE) der Anfangsverknüpfungselemente (AVE) ansteuert, und die abhängig von der durch die externe Steuerung bewirkte Einstellung die verfügbaren Eingangssteuersignale (S) einzeln oder gruppenweise kombiniert den einzelnen Steuereingängen (SE) verschiedener Anfangsverknüpfungselemente (AVE) zuleitet.

5. Schaltungsanordnung nach Anspruch 4, **dadurch gekennzeichnet,** daß der Signalzuordnungsanordnung (SZA1) innerhalb des Halbleiterbausteines eine gesonderte extern einstellbare Verknüpfungsanordnung (VA) vorgeschaltet ist, über die wenigstens ein Teil der verfügbaren Eingangssteuersignale (S) der Signalzuordnungsanordnung (SZA1) geführt werden.

6. Schaltungsanordnung zur Ausführung des Verfahrens nach Anspruch 1, **dadurch gekennzeichnet,** daß den in Halbleiterbausteinen mit hochintegrierter Schaltkreistechnik zusammengefaßten logischen Verknüpfungsschaltungen (VS) mit an den Anfangsverknüpfungselementen (AVE) jeweils wenigstens einem bei der Festlegung der einzelnen Schaltkreisfunktionen unberücksichtigt bleibenden zusätzlichen Steuereingang (SE) eine extern steuerbare, in Abhängigkeit von der externen Steuerung entweder eine Signalkorrektur, eine gegenüber den Verknüpfungsschaltungen (VS) weitere Verknüpfung oder beides durchführende Verknüpfungsanordnung (VA) vorgeschaltet ist, daß die Anschlußstifte des Halbleiterbausteins für externe Signale ($S_{EX}$) und die interne Signale ($S_{IN}$) liefernden Ausgänge von Teilen der Verknüpfungsschaltungen (VS) mit den Eingängen (VAE) der Verknüpfungsanordnung (VA) verbunden sind und daß die Ausgangssignale (S") liefernden Ausgänge der Verknüpfungsanordnung (VA) mit den entsprechenden Steuereingängen (SE) der Anfangsverknüpfungselemente (AVE) der Verknüpfungsschaltungen (VS) fest verbunden sind.

7. Schaltungsanordnung nach Anspruch 5 oder 6, **dadurch gekennzeichnet,** daß der Verknüpfungsanordnung (VA) innerhalb des Halbleiterbausteins eine bezüglich der Zuordnung von an mehreren zugehörigen Eingängen ankommenden Signalen zu unterschiedlich auswählbaren Ausgängen einer zugehörigen Ausgangsgruppe extern steuerbare Signalzuordnungsanordnung (SZA2) vorgeschaltet ist und daß die Anschlußstifte des Halbleiterbausteins für externe Signale ($S_{EX}$) und die interne Signale ($S_{IN}$) liefernden Ausgänge von Teilen der Verknüpfungsschaltungen (VS) mit den Eingängen der Signalzuordnungsanordnung (SZA2) und die Eingänge (VAE) der Verknüpfungsanordnung (VA) mit den entsprechenden Ausgängen der Signalzuordnungsanordnung (SZA2) verbunden sind.

8. Schaltungsanordnung nach einem der Ansprüche 4 bis 7, **dadurch gekennzeichnet,** daß innerhalb des Halbleiterbausteines wenigstens ein extern angesteuertes Schieberegister (SR) zur Einstellung der vorhandenen Signalzuordnungsanordnungen (SZA1, SZA2) vorgesehen ist.

9. Schaltungsanordnung nach Anspruch 8, **dadurch gekennzeichnet,** daß den Ausgängen des Schieberegisters (SR) ein Demultiplexer (DM) nachgeschaltet ist.

**Claims**

1. Method for subsequently influencing the circuit functions of logic circuits assembled in semiconductor modules, using LSI circuit technology, characterised in that, when defining the individual circuit functions, in each case at least one control input (SE) on the initial logic elements (AVE) of the logic circuits (VS) receiving the input signals of the logic circuits (VS) remains unconsidered, and in that all the control inputs (SE) of the initial logic elements (AVE) are driven via a separate circuit part, which is connected upstream and can be controlled externally, consisting of a logic arrangement (VA), which carries out either a signal correction, further logic operations in comparison with the logic circuits (VS) or both, as a function of the external control, and/or of a signal allocation arrangement (SZA1), which is externally controllable with respect to the allocation of signals arriving at a plurality of associated inputs to outputs, which can be selected differently, of an associated output group, to which circuit part the input signals (S$_{EX}$), which are available on the connecting pins of the semiconductor module, and intermediate signals (S$_{IN}$), which are supplied by parts of the logic circuits (VS), are supplied as input control signals (S), so that, as a function of the setting, which is effected by the external control, of the upstream circuit part, the available input control signals (S) are modified in a predetermined manner and/or are supplied, individually or combined into groups, to the individual control inputs (SE) of various initial logic elements (AVE).

2. Method according to Claim 1, characterised in that, when an upstream circuit part is used with the supplied input control signals (S) logically linked, at least a part of these input control signals (S) is supplied to the circuit part via an externally controllable circuit allocation arrangement (SZA2), which supplies the input control signals (S), which are supplied to it, individually or combined into groups, to the inputs of the upstream circuit part, as a function of the setting of said signal allocation arrangement.

3. Method according to Claim 1 or 2, characterised in that the settings of the signal allocation arrangements (SZA1 and/or SZA2) take place via a shift register (SR), if required with a demultiplexer (DM) connected downstream in the semiconductor module.

4. Circuit arrangement for carrying out the method according to Claim 1, characterised in that a signal allocation arrangement (SZA1) which is externally controllable with respect to the allocation of signals arriving at a plurality of associated inputs to outputs, which can be selected differently, of an associated output group, is connected upstream of the logic circuits (VS), which are assembled in semiconductor modules, using LSI circuit technology, with in each case at least one additional control input (SE) which remains unconsidered when defining the individual circuit functions, on the initial logic elements (AVE), which signal allocation arrangement (SZA1) is supplied, as input signals (S), with the input signals (S$_{EX}$), which are available on the connecting pins of the semiconductor module, and intermediate signals (S$_{IN}$), which are supplied by parts of the logic circuits (VS), and, with its output signals (S'''), drives all the control inputs (SE) of the initial logic elements (AVE), and which, as a function of the setting, which is effected by the external control, supplies the available input control signals (S), individually or combined into groups, to the individual control inputs (SE) of various initial logic elements (AVE).

5. Circuit arrangement according to Claim 4, characterised in that a separate, externally adjustable logic arrangement (VA) is connected upstream of the signal allocation arrangement (SZA1) inside the semiconductor module, via which at least a part of the available input control signals (S) is supplied to the signal allocation arrangement (SZA1).

6. Circuit arrangement for carrying out the method according to Claim 1, characterised in that an externally controllable logic arrangement (VA), which carries out either a signal correction, a further logic operation in comparison with the logic circuits (VS) or both, as a function of the external control, is connected upstream of the logic circuits (VS), which are assembled in semiconductor modules using LSI circuit technology, with in each case at least one additional control input (SE), which remains unconsidered when defining the individual circuit functions, on the initial logic elements (AVE), in that the connecting pins of the semiconductor module are connected to the inputs (VAE) of the logic arrangement (VA) for external signals (S$_{EX}$) and the outputs of parts of logic circuits (VS) supplying internal signals (S$_{IN}$) are connected to the inputs (VAE) of the logic arrangement (VA), and in that the outputs, which supply the output signals (S"), of the logic arrangement (VA) are fixedly connected to the corresponding control inputs (SE) of the initial logic elements (AVE) of the logic circuits (VS).

7.    Circuit arrangement according to Claim 5 or 6, characterised in that a signal allocation arrangement (SZA2) which is externally controllable with respect to the allocation of signals arriving at a plurality of associated inputs to outputs, which can be selected differently, of an associated output group, is connected upstream of the logic arrangement (VA) inside the semiconductor module, and in that the connecting pins of the semiconductor module for external signals ($S_{EX}$) and the outputs of parts of the logic circuits (VS) which supply the internal signals ($S_{IN}$) are connected to the inputs of the signal allocation arrangement (SZA2) and the inputs (VAE) of the logic arrangement (VA) are connected to the corresponding outputs of the signal allocation arrangement (SZA2).

8.    Circuit arrangement according to one of Claims 4 to 7, characterised in that at least one externally driven shift register (SR) is provided inside the semiconductor module for setting the existing signal allocation arrangements (SZA1, SZA2).

9.    Circuit arrangement according to Claim 8, characterised in that a demultiplexer (DM) is connected downstream of the outputs of the shift register (SR).

**Revendications**

1.    Procédé pour influer ultérieurement sur des fonctions de circuits combinatoires logiques assemblés dans des modules à semiconducteurs selon la technique des circuits à haute densité d'intégration,
caractérisé par le fait que dans les éléments combinatoires de départ (AVE) des circuits combinatoires (VS), qui reçoivent les signaux d'entrée de ces circuits combinatoires (VS), respectivement au moins une entrée de commande (SE) n'est pas prise en compte lors de la détermination des différentes fonctions de commutation et que toutes les entrées de commande (SE) des éléments combinatoires de départ (AVE) sont commandées par l'intermédiaire d'un élément de circuit particulier branché en amont et commandable de l'extérieur, qui est constitué par un dispositif combinatoire (VA) qui exécute, en fonction de la commande externe, une correction de signaux, une autre combinaison que celle des circuits combinatoires (VS) ou les deux, et/ou par un dispositif (SZA1) d'association de signaux, commandables de l'extérieur pour ce qui concerne l'association de signaux, qui arrivent à plusieurs entrées associées, à des sorties pouvant être sélectionnées différemment, d'un groupe associé de départ, et auquel sont envoyés les signaux d'entrée ($S_{EX}$) disponibles sur les broches de raccordement du module à semiconducteurs et les signaux intermédiaires ($S_{IN}$) délivrés par des parties des circuits combinatoires (VS), en tant que signaux de commande d'entrée (S), en sorte qu'en fonction du réglage, réalisé au moyen d'une commande externe, de l'élément de circuit branché en amont, les signaux de commande d'entrée disponibles (S) sont modifiés d'une manière prédéterminée et/ou sont envoyés individuellement ou combinés par groupes aux différentes entrées de commande (SE) de différents éléments combinatoires de départ (AVE).

2.    Procédé suivant la revendication 1, caractérisé par le fait que, dans le cas de l'utilisation d'un élément de circuit branché en amont, avec combinaison des signaux envoyés de commande d'entrée (S), au moins une partie de ces signaux de commande d'entrée (S) est envoyée à l'élément de circuit par l'intermédiaire d'un dispositif (SZA2), d'association de signaux, commandable de l'extérieur et qui, en fonction de son réglage, envoie les signaux de commande d'entrée (S), qui lui sont envoyés, individuellement ou d'une manière combinée par groupes aux entrées de l'élément de circuit branché en amont.

3.    Procédé suivant la revendication 1 ou 2, caractérisé par le fait que les réglages des dispositifs d'association de signaux (SZA1 et/ou SZA2) s'effectuent par l'intermédiaire d'un registre à décalage (SR), en aval duquel est éventuellement branché un démultiplexeur (DM), dans le module à semiconducteurs.

4.    Montage pour la mise en oeuvre du procédé suivant la revendication 1, caractérisé par le fait qu'en amont des circuits combinatoires logiques (VS), réunis dans des modules à semiconducteurs selon la technique des circuits à haute densité d'intégration, comportant, au niveau des éléments combinatoires de départ (AVE), respectivement au moins une entrée de commande supplémentaire (SE) qui n'est pas prise en considération lors de la détermination des différentes fonctions des circuits, est branché un dispositif d'association de signaux (SZ1), qui est commandable de l'extérieur en ce qui concerne l'association de signaux, qui arrivent à plusieurs entrées associées, à des sorties pouvant être sélectionnées différemment d'un groupe de sorties associé, et qui reçoit les signaux d'entrée ($S_{EX}$) disponibles sur les broches de raccordement du module à semiconducteurs et des signaux intermédiaires ($S_{IN}$), qui sont délivrés par des parties des circuits combinatoires (VS), en tant que signaux d'entrée (S) et commande, par ses signaux de sortie (S'''), toutes les entrées de commande (SE) des éléments combinatoires de départ (VE), et qui, en fonction du réglage exécuté au moyen de la commande externe, envoient les signaux disponibles de commande d'entrée (S) individuellement ou d'une manière combinée par groupes aux entrées individuelles de commande (SE) de différents éléments combinatoires d'entrée (AVE).

5. Montage suivant la revendication 4, caractérisé par le fait qu'en amont du dispositif (SZA1) d'association de signaux, à l'intérieur du module à semiconducteurs, est branché un dispositif combinatoire particulier (VA), réglable de l'extérieur, au moyen duquel au moins une partie des signaux disponibles de commande d'entrée (S) sont envoyés au dispositif (SZA1) d'association de signaux.

6. Montage pour la mise en oeuvre du procédé suivant la revendication 1, caractérisé par le fait qu'au circuits combinatoires logiques (VS) réunis dans le module à semiconducteurs selon la technique des circuits à haute densité d'intégration et qui comportent, au niveau des éléments combinatoires de départ (AVE), respectivement au moins une entrée supplémentaire de commande (SE) qui n'est pas prise en considération lors de la détermination des différentes fonctions des circuits, est branché en amont un circuit combinatoire (VA) commandable de l'extérieur, qui exécute, en fonction de la commande extérieure, une correction de signaux, une autre combinaison que celle formée par les circuits combinatoires (VS) ou bien les deux, que les broches de raccordement du module à semiconducteurs pour des sorties, qui délivrent des signaux externes ($S_{EX}$) et des signaux internes ($S_{IN}$), de parties des circuits combinatoires (VS) sont raccordés aux entrées (VAE) du dispositif combinatoire (VA) et que les sorties du dispositif combinatoire (VA), qui délivrent les signaux de sortie (S''), sont raccordées de façon fixe aux entrées de commande correspondantes (SE) des éléments combinatoires de départ (AVE) des circuits combinatoires (VS).

7. Montage suivant la revendication 5 ou 6, caractérisé par le fait qu'en amont du dispositif combinatoire (VA), à l'intérieur du module à semiconducteurs, est branché un dispositif (SZA2) d'association de signaux, qui est commandable de l'extérieur pour ce qui concerne l'association de signaux arrivant à plusieurs entrées associées, à des sorties pouvant être sélectionnées différemment d'un groupe associé de sorties, et que les broches de raccordement du module à semiconducteurs pour des sorties, qui délivrent des signaux externes ($S_{EX}$) et des signaux internes ($S_{IN}$), de parties des circuits combinatoires (VS) sont raccordées aux entrées du dispositif (SZA2) d'association de signaux et que les entrées (VAE) du dispositif combinatoire (VA) sont raccordées aux sorties correspondantes du dispositif (SZA2) d'association de signaux.

8. Montage suivant l'une des revendications 4 à 7, caractérisé par le fait qu'à l'intérieur du module à semiconducteurs, au moins un registre à décalage (SA) commandé de l'extérieur est prévu pour le réglage des dispositifs existants d'association de signaux (SZA1, SZA2).

9. Montage suivant la revendication 8, caractérisé par le fait qu'un démultiplexeur (DM) est branché en aval des sorties du registre à déclage (SR).

FIG 1

FIG 2

FIG 3

**FIG 4**

**FIG 5**

**FIG 6**

FIG 7

FIG 8

FIG 9

FIG 10

FIG 11